(19) Europäisches Patentamt / European Patent Office / Office européen des brevets

(11) **EP 1 990 877 B1**

(12) **FASCICULE DE BREVET EUROPÉEN**

(45) Date de publication et mention
de la délivrance du brevet:
**04.11.2009 Bulletin 2009/45**

(51) Int Cl.:
***H01S 5/12*** (2006.01)

(21) Numéro de dépôt: **08155834.8**

(22) Date de dépôt: **07.05.2008**

(54) **Lasers semi-conducteur monomodes à contre-réaction répartie**

Monomode-Halbleiterlaser mit verteilter Rückkopplung

Single mode semiconductor lasers with distributed feedback

(84) Etats contractants désignés:
**CH DE FR GB LI SE**

(30) Priorité: **11.05.2007 FR 0703390**

(43) Date de publication de la demande:
**12.11.2008 Bulletin 2008/46**

(73) Titulaire: **THALES**
**92200 Neuilly sur Seine (FR)**

(72) Inventeurs:
• **Carras, Mathieu**
**94250 Gentilly (FR)**
• **De Rossi, Alfredo**
**75014 Paris (FR)**

(74) Mandataire: **Esselin, Sophie et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**FR-A- 2 863 774     US-A1- 2004 042 516**

• **HANSMANN S ET AL: "VARIATION OF COUPLING COEFFICIENTS BY SAMPLED GRATINGS IN COMPLEX COUPLED DISTRIBUTION-FEEDBACK LASERS" IEEE JOURNAL OF SELECTED TOPICS IN QUANTUM ELECTRONICS, IEEE SERVICE CENTER, PISCATAWAY, NJ, US, vol. 1, no. 2, 1 juin 1995 (1995-06-01), pages 341-345, XP000521095 ISSN: 1077-260X**

## Description

La présente invention concerne le domaine des lasers semi-conducteurs à contre-réaction répartie. Plus précisément, l'invention permet de mettre au point des lasers à contre-réaction répartie monomodes avec un taux d'obtention proche de 100% selon une technologie simple et robuste.

Il est connu que le premier objectif de la contre-réaction répartie est d'éliminer au maximum les modes secondaires du laser. Un deuxième objectif est généralement de réduire les pertes miroir, c'est-à-dire les pertes dues à la longueur finie de la cavité du laser.

Actuellement, il existe deux méthodes principales de réalisation de lasers à contre-réaction répartie (lasers DFB, pour Distributed FeedBack en anglais).

Ces deux méthodes connues consistent soit à réaliser une modulation de l'indice effectif de la zone active, soit à réaliser une modulation des pertes, également qualifiée de modulation du gain. D'un point de vue technologique, ces méthodes reposent généralement sur la gravure d'un réseau, qui peut être enterré, c'est-à-dire gravé après la croissance de la zone active mais avant la croissance du guide supérieur du laser, ou localisé en surface du guide supérieur du laser et métallisé.

La modulation de l'indice est théoriquement privilégiée car elle permet d'obtenir un laser DFB sans augmenter les pertes contrairement à la modulation des pertes, généralement plus facile à mettre en oeuvre technologiquement, mais dont le principal défaut est de dégrader le seuil du laser.

En conséquence, et puisque l'on cherche couramment à optimiser le seuil du laser, on préférera effectuer une modulation de l'indice. Cependant, si cette méthode de réalisation de lasers DFB permet bien d'éliminer une grande partie des modes secondaires, il subsiste généralement deux modes principaux, même dans le cas d'une contre-réaction fortement couplée.

Ainsi, pour obtenir un laser monomode, d'autres technologies viennent souvent s'ajouter à celle utilisée pour obtenir une contre-réaction répartie. Le principe est d'introduire des pertes supplémentaires importantes sur le ou les modes parasites.

La première méthode visant à obtenir un laser DFB monomode consiste à mettre en oeuvre une contre-réaction dominée par les pertes optiques. Ces pertes sont dues à l'absorption du rayonnement électromagnétique par les matériaux constitutifs des guides inférieur et supérieur du laser. Cette modulation des pertes peut permettre de n'avoir plus qu'un seul mode mais, pour que le taux de réjection des modes secondaires (SMSR pour Side Mode Rejection Rate en anglais) soit suffisamment élevé, les pertes introduites dégradent le seuil du laser. De plus, l'amplitude des pertes optiques permettant de moduler les pertes du laser est très difficile à maîtriser. Enfin, les pertes optiques touchent systématiquement une zone étendue et affectent donc les deux modes DFB ; ainsi, le mode que l'on cherche à privilégier est tout de même altéré.

Une deuxième technologie consiste à introduire un défaut dans le réseau gravé (réseau enterré ou réseau de surface métallisé). Ce défaut permet de favoriser l'émergence d'un mode unique prépondérant au milieu de la bande interdite qui existerait dans le cas d'une structuration périodique sans défaut. Le principal inconvénient de cette technologie est qu'elle impose de fixer au préalable une grande partie des paramètres géométriques du laser (longueur des cavités, position des miroirs, profondeur des réseaux notamment) parce qu'elle brise l'invariance par translation. La mise au point d'un laser selon cette technologie est donc contraignante et complexe, d'autant plus qu'elle est très sensible à la précision de la réalisation technologique, et en particulier à la profondeur du réseau gravé.

Dans l'art connu, il existe encore d'autres technologies visant à obtenir des lasers monomodes, telles que l'utilisation de réseaux à pas variable ou la mise en oeuvre de la technologie de la réflexion de Bragg distribuée (laser DBR pour Distributed Bragg Reflector en anglais). Cependant, ces technologies, de même que la deuxième technologie évoquée ci-dessus, imposent systématiquement des contraintes géométriques fortes, rendant plus complexe et sensible la réalisation de lasers selon ces technologies.

En résumé, le principal inconvénient des différentes technologies de l'art connu conduisant à la mise au point de lasers DFB monomodes réside soit dans les contraintes géométriques qu'elles imposent, soit dans la dégradation du seuil du laser. Les défauts mentionnés rendent difficiles à maîtriser les technologies d'obtention de lasers DFB monomodes et les taux d'obtention de tels lasers selon ces technologies sont réduits.

Afin de pallier les inconvénients précités, l'invention propose d'introduire au niveau de la zone active, un réseau périodique ayant un profil d'indice particulier, introduisant des pertes radiatives affectant uniquement un des deux modes de bord de la bande interdite, qui sont les deux modes principaux subsistant dans un laser DFB réalisé par modulation de l'indice.

Une utilisation du type de réseaux ou de structures à introduire est décrite dans le cadre de photo-détecteurs à concentration de champ proche dans le brevet français n° 2 863 774.

A cet effet, l'invention a pour objet un laser semi-conducteur comportant au moins :

- un substrat assurant la fonction de support mécanique,
- une zone active, dans laquelle peut se propager selon un axe de propagation un faisceau lumineux présentant une longueur d'onde,
- un guide supérieur,
- un guide inférieur,

ladite zone active comportant un profil d'indice de réfrac-

tion $n_x$ modulé de sorte que ledit indice de réfraction varie de manière périodique le long de l'axe de propagation et présente une période $\Lambda$, la décomposition en séries de Fourier dudit indice de réfraction modulé s'écrivant

$$\left[ n_x = \sum_{N=1}^{\infty} \alpha_N \times \exp\left[ i\frac{2\Pi\Lambda}{N} \right] \right],$$ où N est appelé l'ordre de Fourier, $\alpha_N$ est le coefficient de Fourier d'ordre N du profil d'indice modulé, et i tel que $i^2 = -1$, caractérisé en ce que la période du profil d'indice modulé est telle qu'il existe un entier k supérieur ou égal à 1 pour lequel le paramètre suivant

$$\left[ \frac{\int_0^{\Lambda} n_x . \exp(i\frac{2\Pi\Lambda}{k} x).dx}{\left( \int_0^{\Lambda} n_x . \exp(i\frac{2\Pi\Lambda}{2.k} x).dx \right)^2} \right]$$ est un nombre complexe dont la partie imaginaire
est inférieure à environ un dixième de la partie réelle.

Avantageusement, l'entier k considéré est égal à 1.

Avantageusement, le profil d'indice comprend des motifs périodiques comportant chacun deux créneaux d'égale largeur.

Avantageusement le laser comprend des motifs dopés par des ions dans la zone active de manière à assurer la modulation de l'indice de réfraction de la zone active.

Avantageusement, la zone active est formée d'un nombre entier de périodes constituées chacune d'un empilement de couches épitaxiées de matériaux semiconducteurs tels que InGaAs, AlInAs, GaAs, AlGaAs, InP, de sorte que ledit laser est un laser à cascade quantique (ou QCL pour Quantum Cascade Laser en anglais).

Avantageusement, le substrat est réalisé en GaAs.

Avantageusement, le guide inférieur est réalisé dans un matériau semi-conducteur fortement dopé.

Avantageusement, le guide inférieur est réalisé en InP.

Avantageusement, le guide supérieur est réalisé en InP, ou en InGaAs, ou en AlGaAs.

Avantageusement la zone active est un empilement de fines couches :

- GaAs et AlGaAs,
- AlInAs et GaInAs,
- InAs et AlSb.

D'autres caractéristiques et avantages de l'invention apparaîtront à l'aide de la description qui suit faite en regard des dessins annexés qui représentent :

- la figure 1 : le spectre d'un laser DFB standard à modulation d'indice, selon l'art connu ;
- la figure 2 : le schéma d'un exemple de profil d'indice à introduire pour obtenir d'un laser DFB monomode selon l'invention ;
- la figure 3 : deux courbes indiquant l'amplitude du champ du mode principal et les pertes radiatives générées par le profil d'indice introduit dans le laser selon l'invention ;
- la figure 4 : la courbe des pertes radiatives produites par le profil d'indice introduit sur les bandes inférieure et supérieure du laser selon l'invention ;
- la figure 5 : l'illustration schématique d'un exemple de réalisation d'un laser selon l'invention.

Nous allons décrire l'invention dans le cadre d'un laser DFB dans lequel deux modes prépondérants coexistent, le premier se trouve dans la bande d'énergie dite supérieure 8, le second se situe dans la bande d'énergie dite inférieure 9.

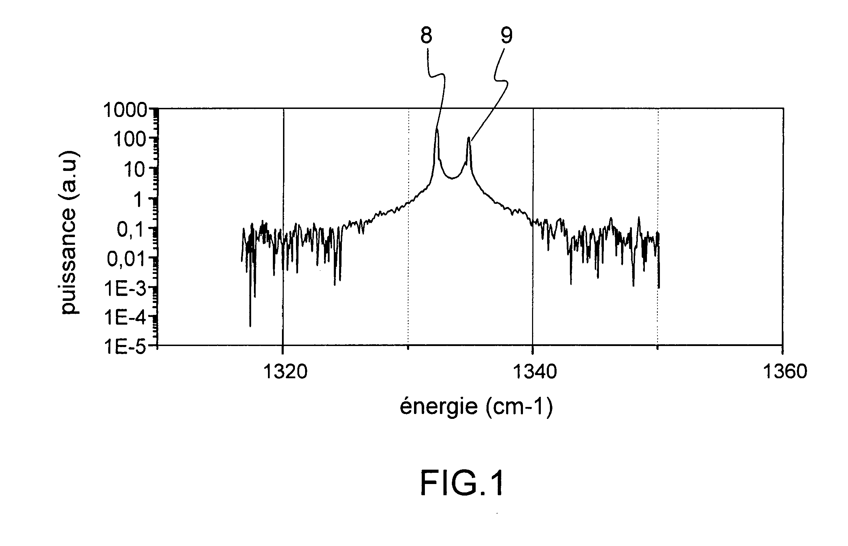

La figure 1 présente le spectre d'un tel laser. Le mode de la bande supérieure 8 a ses maxima de champ au niveau du maximum d'indice dans le cas d'une modulation de l'indice effectif de la zone active 1, au niveau du bas des créneaux dans le cas d'un réseau métallique gravé en surface du guide supérieur 2 du laser. Réciproquement, le mode de la bande inférieure 9 a ses maxima de champ au niveau du minimum d'indice dans le cas d'une modulation de l'indice effectif de la zone active 1, au niveau du haut des créneaux dans le cas d'un réseau métallique gravé en surface du guide supérieur 2 du laser.

Les deux modes prépondérants qui coexistent au sein du laser DFB considéré sont donc bien spatialement définis. Il est par conséquent possible d'introduire des pertes n'affectant qu'un des deux modes.

Dans le cadre de l'invention, la modulation d'indice permettant d'obtenir une contre-réaction répartie peut avoir été introduite par un quelconque procédé technologique : implantation, gravure d'un réseau périodique entre la zone active 1 et le guide supérieur 2 ou tout autre procédé technologique connu ou futur.

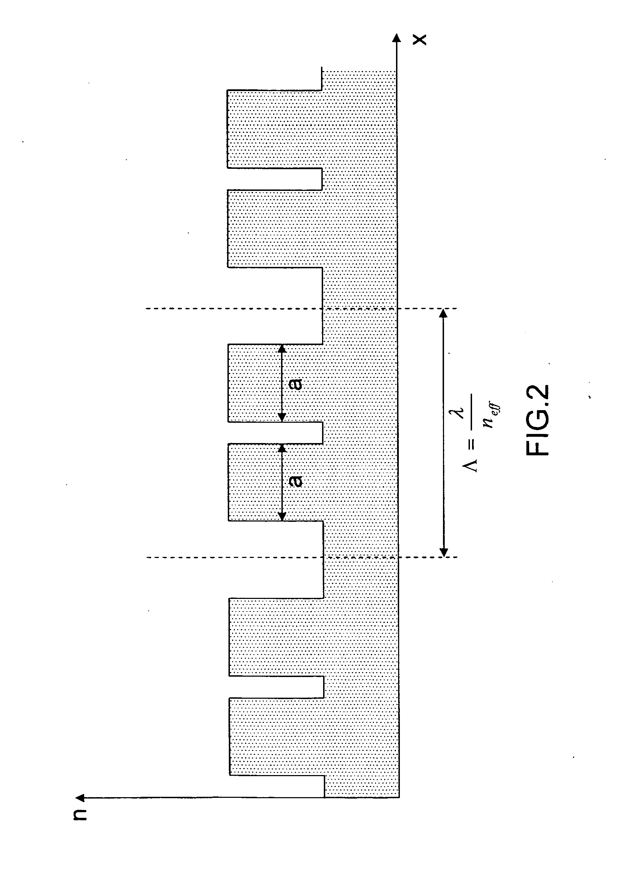

La figure 2 présente un exemple de profil d'indice à introduire pour obtenir l'effet escompté, soit un laser DFB monomode. En effet, ce profil permet l'apparition d'une composante radiative qui génère des pertes importantes uniquement pour l'un des deux modes prépondérants.

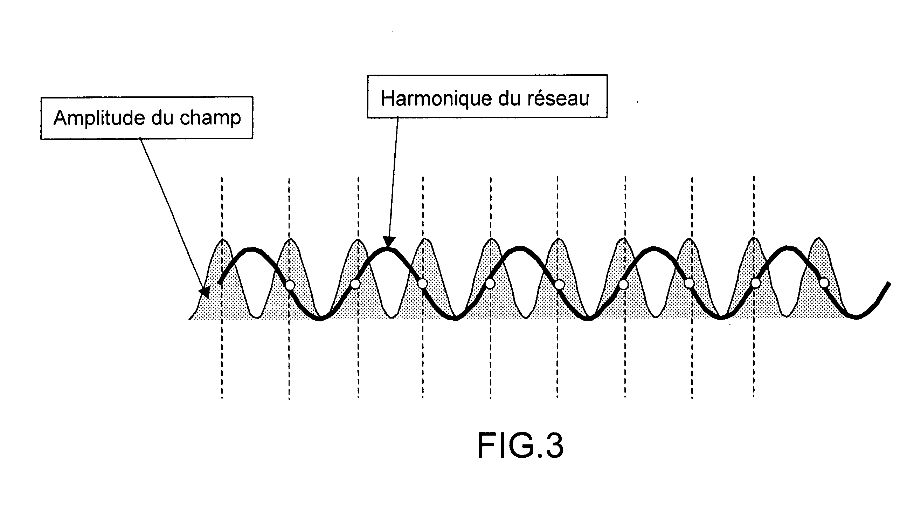

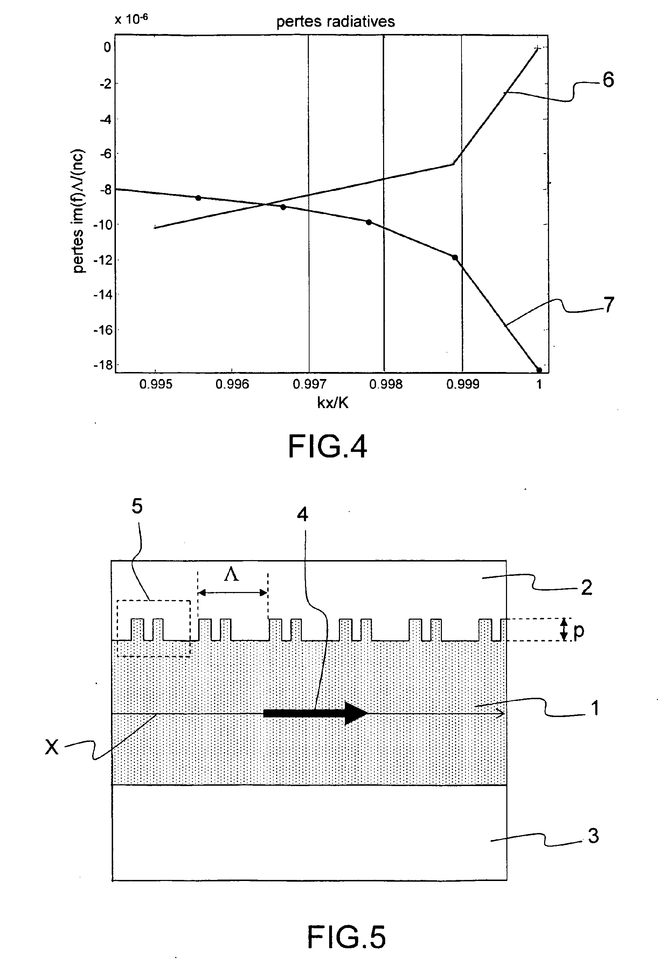

Le profil du motif ayant été judicieusement choisi, les pertes sont importantes pour un mode, et quasinulles pour l'autre mode, comme le montrent les figures 3 et 4, pour lesquelles un exemple de laser DFB selon l'invention a été réalisé avec une zone active 1 constituée d'un empilement de fines couches AlInAs et GaInAs, un guide inférieur 3 et un guide supérieur 2 en InP, et un réseau périodique gravé selon le motif 5 introduisant un profil d'indice tel que décrit dans la figure 2.

La figure 3 illustre la possibilité d'introduire des pertes radiatives sélectives, qui n'affectent que la bande que l'on souhaite éliminer. On constate en effet que l'on peut choisir le motif 5 du réseau périodique de telle façon que les zéros de l'harmonique correspondant aux pertes radiatives générées coïncident avec les maxima du champ du mode auquel on souhaite ajouter ces pertes radiatives.

La figure 4 illustre la sélectivité des pertes radiatives, exprimées lors de la description de la figure 3. Les courbes indiquent clairement qu'il est possible de générer des pertes de la bande supérieure 6 très importantes et en même temps des pertes de la bande inférieure 7 extrêmement réduites.

La figure 5 est relative à un exemple de laser selon l'invention dans lequel on a gravé entre la zone active 1 et le guide supérieur 2 un réseau de période $\Lambda$ et de profondeur p introduisant, pour le faisceau lumineux 4 se propageant selon l'axe X, le profil d'indice décrit dans la figure 2. Le motif 5 comporte deux créneaux d'égale largeur. Il n'existe pas de contrainte de précision forte sur la profondeur p.

En résumé, l'invention a pour principal avantage de permettre la réalisation de lasers DFB monomodes de façon aisée. D'autre part, la sélectivité des pertes radiatives étant maîtrisée, l'invention permet de produire ces lasers DFB monomodes avec un taux d'obtention proche de 100%.

## Revendications

**1.** Laser semi-conducteur comportant au moins :

• un substrat assurant la fonction de support mécanique,
• une zone active (1), dans laquelle se propage selon un axe de propagation (X) un faisceau lumineux (4) présentant une longueur d'onde ($\lambda$),
• un guide supérieur (2),
• un guide inférieur (3),

ladite zone active (1) comportant un profil d'indice de réfraction ($n_x$) modulé de sorte que ledit indice de réfraction ($n_x$) varie de manière périodique le long de l'axe de propagation (X) et présente une période ($\wedge$), la décomposition en séries de Fourier dudit indice de réfraction modulé ($n_x$) s'écrivant

$$\left[ n_x = \sum_{N=1}^{\infty} \alpha_N \times \exp\left[ i\frac{2\Pi\Lambda}{N} \right] \right],$$

où N est
appelé l'ordre de Fourier, $\alpha_N$ est le coefficient de Fourier d'ordre N du profil d'indice modulé ($n_x$), et i tel que $i^2 = -1$, **caractérisé en ce que** la période ($\wedge$) du profil d'indice modulé ($n_x$) est telle qu'il existe un entier k supérieur ou égal à 1 pour lequel le paramètre suivant

$$\left[ \frac{\int_0^\Lambda n_x \cdot \exp(i\frac{2\Pi\Lambda}{k} x).dx}{\left( \int_0^\Lambda n_x \cdot \exp(i\frac{2\Pi\Lambda}{2k} x).dx \right)^2} \right]$$

est un nombre complexe dont la partie imaginaire est inférieure à un dixième de la partie réelle.

**2.** Laser selon la revendication 1, **caractérisé en ce que** l'entier k considéré est égal à 1.

**3.** Laser selon la revendication 1, **caractérisé en ce qu'**il comprend un profil d'indice dont chaque motif périodique comprend deux créneaux d'égale largeur.

**4.** Laser selon la revendication 1, **caractérisé en ce qu'**il comprend des motifs dopés par des ions dans la zone active (1) de manière à assurer la modulation de l'indice de réfraction ($n_x$) de la zone active (1).

**5.** Laser selon l'une quelconque des revendications 1 à 4, **caractérisé en ce que** la zone active dudit laser est formée d'un nombre entier de périodes constituées chacune d'un empilement de couches épitaxiées de matériaux semi-conducteurs tels que InGaAs, AlInAs, GaAs, AlGaAs, InP, de sorte que ledit laser est un laser à cascade quantique (ou QCL pour Quantum Cascade Laser en anglais).

**6.** Laser selon l'une quelconque des revendications 1 à 5, **caractérisé en ce que** le substrat est réalisé en GaAs.

**7.** Laser selon l'une quelconque des revendications 1 à 6, **caractérisé en ce que** le guide inférieur (3) est réalisé dans un matériau semi-conducteur fortement dopé.

**8.** Laser selon l'une quelconque des revendications 1 à 7, **caractérisé en ce que** le guide inférieur (3) est réalisé en InP.

**9.** Laser selon l'une quelconque des revendications 1 à 8, **caractérisé en ce que** le guide supérieur (2) est réalisé en InP, ou en InGaAs, ou en AlGaAs.

**10.** Laser selon l'une quelconque des revendications 1 à 9, **caractérisé en ce que** la zone active (1) est un empilement de fines couches :

• GaAs et AlGaAs,
• AllnAs et GalnAs,
• InAs et AlSb.

**Claims**

1. Semiconductor laser comprising at least:

   • a substrate providing the mechanical support function,
   • an active area (1), in which is propagated along a propagation axis (X) a light beam (4) having a wavelength (X),
   • a top waveguide (2),
   • a bottom waveguide (3),
   said active area (1) comprising a refractive index profile ($n_x$) modulated so that said refractive index ($n_x$) varies periodically along the propagation axis (X) and has a period $\wedge$, the Fourier series breakdown of said modulated refractive index ($n_x$) being expressed

   $$\left[ n_x = \sum_{N=1}^{\infty} \alpha_N \times \exp\left[ i\frac{2\Pi\Lambda}{N} \right] \right],$$

   where N is called the Fourier order, $\alpha_N$ is the Nth order Fourier coefficient of the modulated index profile ($n_x$), and i is such that $i^2=-1$, **characterized in that** the period ($\wedge$) of the modulated index profile ($n_x$) is such that there is an integer k greater than or equal to 1 for which the following parameter

   $$\left[ \frac{\int_0^{\Lambda} n_x . \exp(i\frac{2\Pi\Lambda}{k}x).dx}{\left( \int_0^{\Lambda} n_x . \exp(i\frac{2\Pi\Lambda}{2k}x).dx \right)^2} \right]$$

   is a complex number, the imaginary part of which is less than a tenth of the real part.

2. Laser according to Claim 1, **characterized in that** the integer k concerned is equal to 1.

3. Laser according to Claim 1, **characterized in that** it comprises an index profile, of which each periodic pattern comprises two pulses of each equal width.

4. Laser according to Claim 1, **characterized in that** it comprises ion-doped patterns in the active area (1) so as to provide the modulation of the refractive index ($n_x$) of the active area (1).

5. Laser according to any one of Claims 1 to 4, **characterized in that** the active area of said laser is made up of an integer number of periods, each comprising a stack of epitaxial layers of semiconductor materials such as InGaAs, AllnAs, GaAs, AlGaAs, InP, such that said laser is a quantum cascade laser (QCL).

6. Laser according to any one of Claims 1 to 5, **characterized in that** the substrate is made of GaAs.

7. Laser according to any one of Claims 1 to 6, **characterized in that** the bottom waveguide (3) is made of a highly doped semiconductor material.

8. Laser according to any one of Claims 1 to 7, **characterized in that** the bottom waveguide (3) is made of InP.

9. Laser according to any one of Claims 1 to 8, **characterized in that** the top waveguide (2) is made of InP, or of InGaAs, or of AlGaAs.

10. Laser according to any one of Claims 1 to 9, **characterized in that** the active area (1) is a stack of thin layers:

    • GaAs and AlGaAs,
    • AllnAs and GalnAs,
    • InAs and AlSb.

**Patentansprüche**

1. Halbleiterlaser, umfassend mindestens:

   - ein Substrat, das die mechanische Trägerfunktion erfüllt,
   - eine aktive Zone (1), in der sich ein Lichtstrahl (4), der eine Wellenlänge (λ) aufweist, einer Ausbreitungsachse (X) entsprechend ausbreitet,
   - einen oberen Leiter (2),
   - einen unteren Leiter (3),

   wobei diese aktive Zone (1) ein BrechungsindexProfil ($n_x$) aufweist, das derart moduliert wird, dass der Brechungsindex ($n_x$) entlang der Ausbreitungsachse (X) auf periodische Weise variiert und eine Periode (λ) aufweist, wobei die Zerlegung dieses modulierten Brechungsindexes ($n_x$) in Fourierreihen

$$\left[ n_x = \sum_{N=1}^{\infty} \alpha_N \times \exp\left[ i\frac{2\Pi\Lambda}{N} \right] \right]$$

geschrieben

wird, wobei N die Fourierordnung genannt wird, $\alpha_N$ der Fourierkoeffizient der Ordnung N des modulierten Brechungsindex-Profils ($n_x$) ist, und i derart ist, dass $i^2 = -1$, **dadurch gekennzeichnet, dass** die Periode ($\lambda$) des modulierten Brechungsindex-Profils ($n_x$) derart ist, dass es eine Ganzzahl k größer oder gleich 1 gibt, für welche der folgende Parameter

$$\left[ \frac{\int_0^\Lambda n_x \cdot \exp(i\frac{2\Pi\Lambda}{k} x).dx}{\left( \int_0^\Lambda n_x \cdot \exp(i\frac{2\Pi\Lambda}{2k} x).dx \right)^2} \right]$$

eine komplexe Zahl ist, deren Imaginärteil kleiner als ein Zehntel des Realteils ist.

2. Laser nach Anspruch 1, **dadurch gekennzeichnet, dass** die in Betracht gezogene Ganzzahl k gleich 1 ist.

3. Laser nach Anspruch 1, **dadurch gekennzeichnet, dass** er ein Indexprofil aufweist, wovon jedes periodische Muster zwei Zeitschlitze gleicher Breite umfasst.

4. Laser nach Anspruch 1, **dadurch gekennzeichnet, dass** er in der aktiven Zone (1) Muster umfasst, die derart mit Ionen dotiert sind, dass sie die Modulation des Brechungsindexes ($n_x$) der aktiven Zone (1) gewährleisten.

5. Laser nach einem der Ansprüche 1 bis 4, **dadurch gekennzeichnet, dass** die aktive Zone des Lasers aus einer ganzen Zahl von Perioden geformt ist, die alle aus einem Stapel expitaxischer Schichten aus Halbleitermaterialien wie InGaAs, AlnAs, GaAs, AlGaAs, InP derart aufgebaut sind, dass dieser Laser ein Quantenkaskadenlaser (oder QCL für Quantum Cascade Laser auf Englisch) ist.

6. Laser nach einem der Ansprüche 1 bis 5, **dadurch gekennzeichnet, dass** das Substrat aus GaAs hergestellt ist.

7. Laser nach einem der Ansprüche 1 bis 6, **dadurch gekennzeichnet, dass** der untere Leiter (3) aus einem stark dotierten Halbleitermaterial hergestellt ist.

8. Laser nach einem der Ansprüche 1 bis 7, **dadurch gekennzeichnet, dass** der untere Leiter (3) aus InP hergestellt ist.

9. Laser nach einem der Ansprüche 1 bis 8, **dadurch gekennzeichnet, dass** der obere Leiter (2) aus InP oder aus InGaAs oder aus AlGaAs hergestellt ist.

10. Laser nach einem der Ansprüche 1 bis 9, **dadurch gekennzeichnet, dass** die aktive Zone (1) ein Stapel aus feinen Schichten ist:

    - GaAs und AlGaAs,
    - AlInAs und GaInAs,
    - InAs und AlSb.

FIG.1

EP 1 990 877 B1

$$\Lambda = \frac{\lambda}{n_{eff}}$$

FIG.2

FIG.3

x 10⁻⁶                    pertes radiatives

FIG.4

FIG.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2863774